# EUROPEAN PATENT APPLICATION

(11) **EP 2 785 165 A1**
(43) Date of publication of application: **01.10.2014**
(21) Application number: 12850806.6
(22) Date of filing: 23.03.2012
(51) Int. Cl.: H05K 7/14

(54) **OBLIQUELY OUTGOING HEAD FRAME OF OPTICAL MODULE AND COMMUNICATION EQUIPMENT**

(30) Priority: 24.11.2011 CN 201120473838 U
(71) Applicant: ZTE Corporation, Shenzhen, Guangdong 518057 (CN)
(72) Inventor: DAI, Zaixing, Shenzhen Guangdong 518057 (CN); YANG, Tao, Shenzhen Guangdong 518057 (CN); YANG, Shilin, Shenzhen Guangdong 518057 (CN); WANG, Weizhou, Shenzhen Guangdong 518057 (CN)
(74) Representative: Carpintero Lopez, Francisco
(86) International application number: PCT/CN2012/072972
(87) International publication number: WO 2013/075437

(57) **Abstract**

The present invention provides a mounting bracket supporting one or more bevelled-out optical modules and a communication device. The mounting bracket includes: a mounting base (401) disposed to be connected to and mounted on a panel of equipment; at least one optical module guide rail outlet (403), diagonally running through and fixed on an outlet support structure (405) and the mounting base (401), and disposed to run through and be pushed into an optical module guide rail along a bevel direction of the at least one optical module guide rail; and the outlet support structure (405), disposed around the optical module guide rail outlet (403), and fit-connected to the mounting base (401). The outlet support structure (405) is disposed in parallel to the mounting base (401). By means of the technical solutions provided by the present invention, the problem of the difficulty in mounting incurred by inconsistency of the mounting directions of the straight-out device and the bevelled-out optical module in a PCB in the relevant technology is solved, thereby achieving the effect of preventing a straight-out device from affecting the bevelled-out mounting of an optical module.

## Description

### Technical Field

The present invention relates to the filed of communication device, and specifically relates to a mounting bracket supporting one or more bevelled-out optical modules and a communication device.

### Background

With the rapid development of communication devices, there is a higher and higher demand on the transmission rate of equipment, the capacity of an optical fiber, the storage capacity of equipment, and the diversification of connecting devices of the equipment. However, under the limited space, it requires the optimization of the layout. As a necessity to the optical fiber transmission, optical modules are widely used on equipment.

In practical use, the optical module can be used in either straight-out or bevelled-out manner in the single-plate module, the box structure, and the cavity structure. However, when a single plate is provided in a case and is used in a cabinet of the equipment of a computer room, the restraint of the depth of the cabinet and the too-close distance between the front faces of a door of the cabinet and the single plate usually lead to a limited optical fiber curving space of a port of the optical module, the straight-out is difficult to solve for an optical fiber cable requiring a certain of bending radius, so that the optical module needs to be bevelled-out by an angle so as to increase the bending radius to avoid breaking the optical fiber cable caused by too small bending radius.

In addition, for some single plates and box bodies which are fully equipped in layout of a printed circuit board (PCB), the optical module can usually be bevelled-out to optimize outlet devices of the PCB so as to increase the space of the layout.

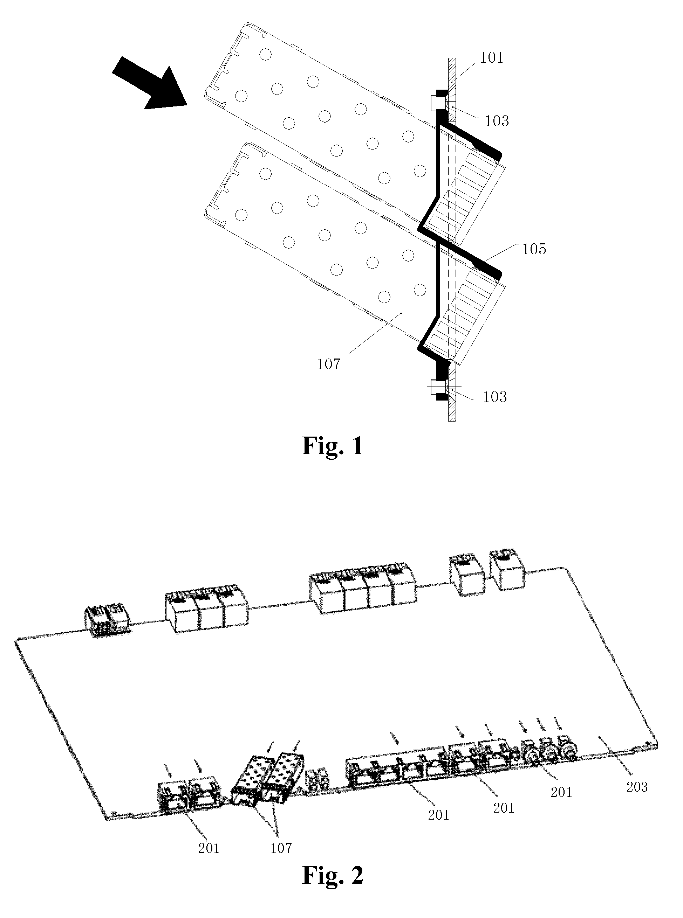

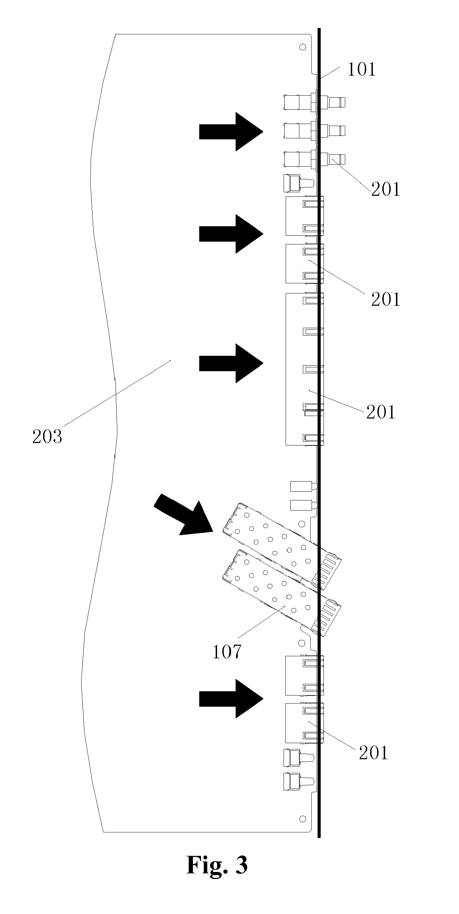

For a single plate only provided with a bevelled-out optical module in the PCB layout, in the related art, the structural pattern as shown in Fig. 1 is used, wherein a panel 101, a sunk screw 103, a mounting bracket 105, and an optical module guide rail 107. Firstly, the mounting bracket 105 and the panel 101 are fixedly connected through the sunk screw 103 to be used as a whole structural member, then when the PCB provided with the optical module guide rail 107 is pushed in, the PCB is obliquely pushed in according to the manner of an arrow as shown in the figure. However, this way of resolution has a better effect on a PCB only provided with bevelled-out outlet devices, the structural members are classified as a whole, and the electronic components are classified as a whole. As shown in Fig.2 and Fig. 3, when there are not only bevelled-out optical modules but also straight-out devices 201 (such as a internet access device, a serial port device, a coaxial connector) arranged on the PCB 203, the mounting directions of the straight-out devices 201 and the optical module guide rail 107 are as the arrows shown in Fig. 3, one requiring straightly pushing, and one requiring obliquely pushing, which forms a contradiction so as to be difficult for mounting.

Aiming at the above-mentioned problems in the relevant technology, no effective solution has been presented.

### Summary

For the problem of the difficulty in mounting incurred by inconsistency of the mounting directions of the straight-out device and the bevelled-out optical module in a PCB in the relevant technology, the present invention provides a mounting bracket supporting one or more bevelled-out optical modules and a communication device to at least solve the above-mentioned problem.

According to one aspect of the present invention, a mounting bracket supporting one or more bevelled-out optical modules is provided, including: a mounting base disposed to be connected to and mounted on a panel of equipment; at least one optical module guide rail outlet, diagonally running through and fixed on an outlet support structure and the mounting base, and disposed to run through and be pushed into an optical module guide rail along a bevel direction of the optical module guide rail; and the outlet support structure, disposed around the at least one optical module guide rail outlet, and fit-connected to the mounting base; wherein the outlet support structure is disposed in parallel to the mounting base.

The above-mentioned mounting bracket also includes a first printed circuit board (PCB) support group, disposed at one side of the mounting base and disposed to connect with a PCB.

The above-mentioned mounting bracket also includes a second PCB support group, disposed at the opposite side of the first PCB support group and disposed to connect with the PCB.

Each of the above-mentioned first PCB support group and second PCB support group includes at least two PCB supports.

The PCB supports in each of the above-mentioned first PCB support group and second PCB support group are all provided with mounting hole structures which are disposed to mate with bolt holes on the PCB, and the PCB supports are connected to the PCB through outside bolts.

The above-mentioned outlet support structure is a rectangular frame which is hollow in the middle.

The above-mentioned mounting bracket includes conductive cloth disposed on the mounting base and disposed to allow the mounting base to be fit-connected to the panel.

There are multiple optical module guide rail outlets.

According to another aspect of the present invention, a communication device is provided, including the above-mentioned mounting bracket.

By means of the present invention, the technical means of arranging an outlet support structure parallel to a mounting base at the optical module guide rail outlet side of the mounting bracket supporting one or more bevelled-out optical modules is used, so that when the optical module guide rail is pushed into the optical module guide rail outlet, the optical module guide rail and the mounting bracket supporting one or more bevelled-out optical modules can be wholly regarded as a straight-out device so as to solve the problem of the difficulty in mounting incurred by inconsistency of the mounting directions of the straight-out device and the bevelled-out optical module in a PCB in the relevant technology, thereby achieving the effect of preventing a straight-out device from affecting the bevelled-out mounting of an optical module.

### Brief description of the drawings

Drawings, provided for further understanding of the present invention and forming a part of the specification, are used to explain the present invention together with embodiments of the present invention rather than to limit the present invention. In the accompanying drawings:
Fig. 1 is a structure diagram of the use of a mounting bracket according to the related art;
Fig. 2 is a structure diagram of a PCB including straightly and bevelled-out optical modules according to the related art;
Fig. 3 is a structure diagram of an overlooking projection of a PCB including straightly and bevelled-out optical modules according to the related art;
Fig. 4 is a structure diagram of a mounting bracket supporting one or more bevelled-out optical modules according to the present invention;
Fig. 5 is a section diagram of a mounting bracket supporting one or more bevelled-out optical modules according to the present invention;
Fig. 6 is a structure diagram of a planar projection of a PCB provided with a mounting bracket supporting one or more bevelled-out optical modules according to the present invention;
Fig. 7 is a decomposition structure diagram of an mounting bracket supporting one or more bevelled-out optical modules used on a single plate according to the present invention;
Fig. 8 is a structure diagram of an mounting bracket supporting one or more bevelled-out optical modules installed on a single plate according to the present invention;
Fig. 9 is a mounting bracket supporting bevelled-out optical modules according to the present invention;

### Detailed Description of the Embodiments

The present invention is described below with reference to the accompanying drawings and embodiments in detail. Note that, the embodiments of the disclosure and the features of the embodiments can be combined with each other if there is no conflict.

### Embodiment 1

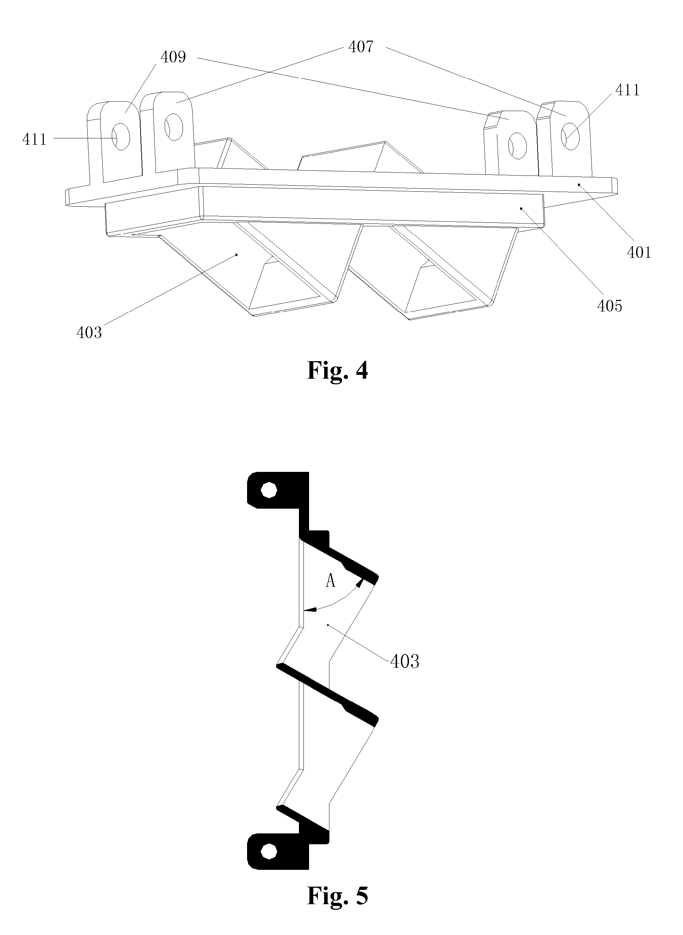

Fig. 4 is a structure diagram of a mounting bracket supporting one or more bevelled-out optical modules according to the related art. As shown in Fig. 4, the mounting bracket supporting one or more bevelled-out optical modules includes:
a mounting base 401, disposed to be connected to and mounted on a panel of equipment;
at least one optical module guide rail outlet 403, diagonally running through and fixed on an outlet support structure 405 and the mounting base 401, and disposed to run through and be pushed into an optical module guide rail along a bevel direction of the optical module guide rail;
and the outlet support structure 405, disposed around the at least one optical module guide rail outlet 403, and fit-connected to the mounting base 401;
the outlet support structure 405 is disposed in parallel to the mounting base 401.

During a specific implementation, the at least one optical module guide rail outlet 403 and the outlet support structure 405 form a certain angle so as to allow the optical module guide rail to be pushed in as a straight-out device, specific reference can be seen Fig. 5, in Fig. 5, the above-mentioned angle is A. However, the outlet support structure 405 is straight; therefore, the optical module guide rail and the mounting bracket can be wholly regarded as a straight-out device.

By means of the above-mentioned structure, since the outlet support structure parallel to the mounting base is arranged at the optical module guide rail outlet side of the mounting bracket supporting one or more bevelled-out optical modules, when the optical module guide rail is pushed into the optical module guide rail outlet, the optical module guide rail and the mounting bracket supporting one or more bevelled-out optical modules can be wholly regarded as a straight-out device so as to solve the problem of the difficulty in mounting incurred by inconsistency of the mounting directions of the straight-out device and the bevelled-out optical module in a PCB, thereby preventing a straight-out device from affecting the bevelled-out mounting of an optical module.

In a specific implementation of the present invention, as shown in Fig. 4, the above-mentioned mounting bracket can also include: a first PCB support group 407, disposed at one side of the mounting base 401 and disposed to connect with a PCB.

In a preferred implementation of the present invention, as shown in Fig. 4, in order to achieve the consistency of the mounting of a daughter card and a mother card, there is no need to redesign because of the inverse relationship, the above-mentioned mounting bracket can also include: a second PCB support group 409, disposed at the opposite side of the first PCB support group 407 and disposed to connect with the PCB.

Each of the above-mentioned first PCB support group 407 and second PCB support group 409 includes at least two PCB supports.

The PCB supports in the above-mentioned first PCB support group 407 and second PCB support group 409 can be connected with a PCB by manners of welding, bonding, etc. the manner of bolted connection is used in a preferred implementation of the present invention, specifically, as shown in Fig. 4, the PCB supports in the first PCB support group 407 and the second PCB support group 409 are all provided with mounting hole structures 411 which are disposed to mate with bolt holes on the PCB, and the PCB supports are connected to the PCB through the outside bolts.

In a preferred implementation of the present invention, the above-mentioned outlet support structure 405 is a rectangular frame which is hollow in the middle and is arranged around the at least one optical module guide rail outlet 403.

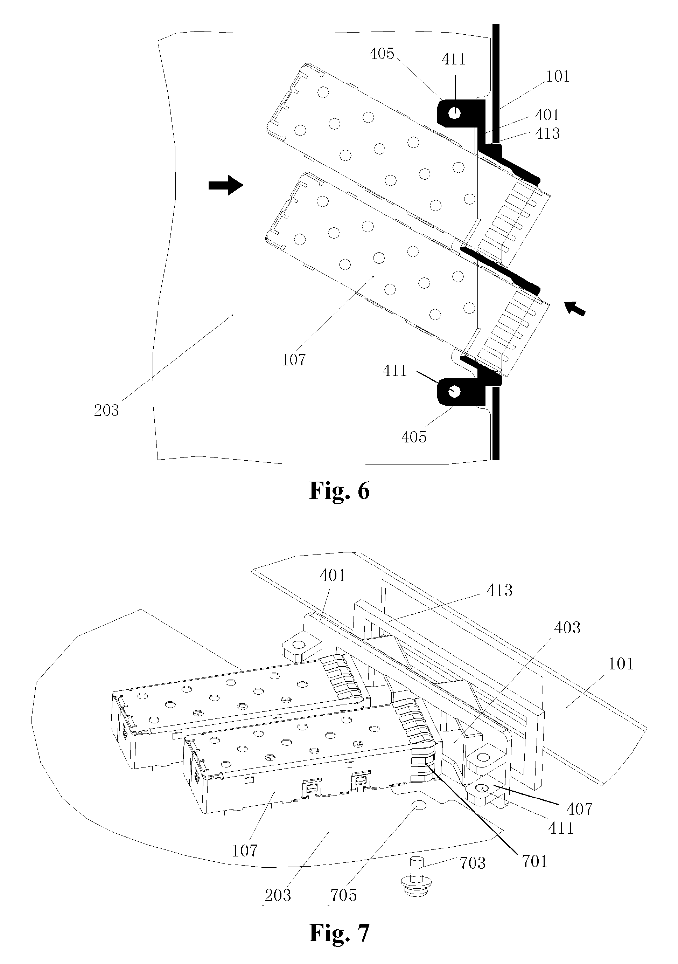

In order to reduce the gap between the mounting base 401 and the outside panel, as shown in Fig. 7, the above-mentioned mounting bracket includes conductive cloth 413 disposed on the mounting base 401 and disposed to allow the mounting base 401 to be fit-connected to the panel.

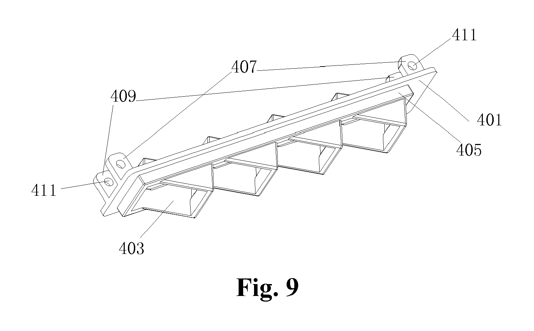

In a preferred implementation of the present invention, there may be multiple optical module guide rail outlets 403, such as, in Fig. 9, the number of the optical module guide rail outlets can be 4.

Since the above-mentioned mounting bracket is usually applied to equipment in practical application, the present invention provides communication device which includes the above-mentioned mounting bracket.

### Embodiment 2

The present invention provides a mounting bracket suitable for supporting one or more bevelled-out optical module, which can not only support an optical module bevelled-out panel, but also can solve the problem of the difficulty in mounting incurred by inconsistency of the mounting directions of the straight-out device and the bevelled-out optical module when both are provided in a PCB.

As shown in Fig. 4 and Fig. 5, the mounting bracket of the present embodiment consists of a first PCB support group 407, a second PCB support group 409, a PCB mounting hole 411 (can be a threaded hole), at least one optical module guide rail outlet 403, a panel outlet support structure 405 and a mounting bracket mounting base 401, wherein the angle between the at least one optical module guide rail outlet 403 and the outlet support structure 405 is A.

In the present embodiment, the optical module can be a small form-factor pluggable (SFP) module and a quad small form-factor pluggable (QSFP) module.

In the present embodiment, the above-mentioned at least one optical module guide rail outlet 403 can be single group, two groups, four groups, etc. the number of the outlets can be changeable, can be one or more, and is defined according the number of the optical module guide rails placed on the PCB, the present embodiment takes two guide rail outlets as an example.

In the present embodiment, the panel can be a single-plate structure needing an outlet device, a box structure, and a cavity structure. The outlet of the panel can be blanked and processed according to the size of a panel outlet support.

The bevel angle (that is, bevel structure) of the optical module guide rail outlet in the present embodiment can be set according to the bevel angle of the optical module guide rail placed on the PCB.

In the present embodiment, the traditional design of using a structural member as a structural member, and using an electronic component as an electronic component is broken, the mounting bracket is used as an electronic component to be arranged on the PCB and is processes as a straight-out device.

For a better understanding of the use manner of the mounting bracket in the above-mentioned embodiment, the following detailed description is given with accompanying drawings.

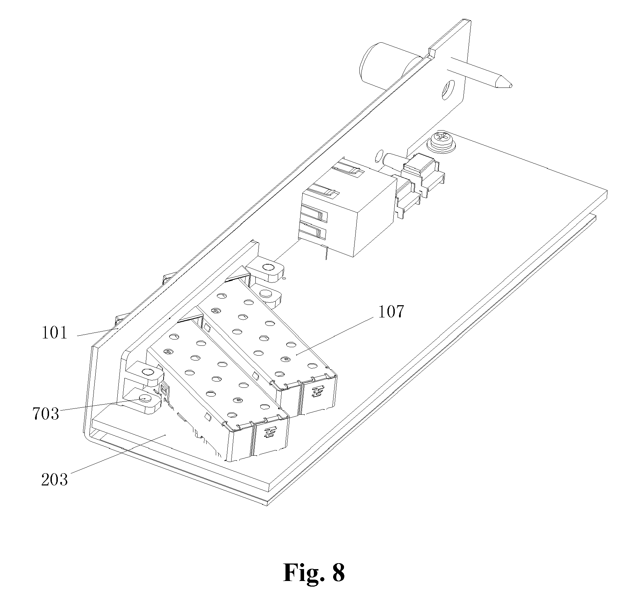

As shown in Figs. 6, 7 and 8, the mounting bracket is firstly pushed in along the bevel direction of the optical module guide rail 107, so that the optical module guide rail 107 can be pushed into the optical module guide rail outlet 403 smoothly, and a shielding reed 701 at the front end of the optical module guide rail 107 can be in full contact with the material side of the mounting bracket, furthermore, the first PCB support group 407 matches with the front face of the PCB 203, the PCB mounting hole structure 411 (being a threaded hole) aligns at a mounting opening 705 on the PCB 203, after the cooperation is in place, the mounting bracket is fixed on the PCB 203 using a combination screw 703 from the back surface of the PCB 203. At the moment, the mounting bracket and the optical module guide rail 107 form a new false device (namely, a straight outgoing device) and then are straightly pushed into a corresponding opening on the panel 101.

The gap between the mounting bracket and the panel can be compensated by a die cutting conductive cloth 413, one end face of the die cutting conductive cloth 413 fits to the mounting base 401 of the mounting bracket, the panel outlet support structure 405 is hollow in the middle and surrounds the panel of the mounting bracket, when the PCB 203 is straightly pushed into the panel 101, the die cutting conductive cloth 413 is pressed, and the other end face fits to the inner side of the panel 101 so as to achieve the process of shielding an opening device.

The descriptions above are only the preferable embodiment of the present invention, which are not used to restrict the present invention, for those skilled in the art, the present invention may have various changes and variations. Any amendments, equivalent substitutions, improvements, etc. within the principle of the present invention are all included in the scope of the protection of the present invention.

## Claims

1. A mounting bracket supporting one or more bevelled-out optical modules, **characterized by** comprising:
a mounting base disposed to be connected to and mounted on a panel of equipment;
at least one optical module guide rail outlet, diagonally running through and fixed on an outlet support structure and the mounting base, and disposed to run through and be pushed into an optical module guide rail along a bevel direction of the optical module guide rail; and
the outlet support structure, disposed around the at least one optical module guide rail outlet, and fit-connected to the mounting base;
wherein the outlet support structure is disposed in parallel to the mounting base.

2. The mounting bracket according to claim 1, **characterized by** further comprising:
a first printed circuit board (PCB) support group, disposed at one side of the mounting base and disposed to connect with a PCB.

3. The mounting bracket according to claim 2, **characterized by** further comprising:
a second PCB support group, disposed at the opposite side of the first PCB support group and disposed to connect with the PCB.

4. The mounting bracket according to claim 3, **characterized in that** each of the first PCB support group and the second PCB support group comprises at least two PCB supports.

5. The mounting bracket according to claim 4, **characterized in that**
the PCB supports in each of the first PCB support group and the second PCB support group are all provided with mounting hole structures which are disposed to mate with bolt holes on the PCB, and the PCB supports are connected to the PCB through outside bolts.

6. The mounting bracket according to claim 1, **characterized in that** the outlet support structure is a rectangular frame which is hollow in the middle.

7. The mounting bracket according to claim 1, **characterized by** comprising conductive cloth disposed on the mounting base and disposed to allow the mounting base to be fit-connected to the panel.

8. The mounting bracket according to claim 1, **characterized in that** there are multiple optical module guide rail outlets.

9. A communication device, **characterized by** comprising the mounting bracket of any one of claims 1 to 9.
